# EUROPEAN PATENT APPLICATION

(11) **EP 1 594 002 A2**
(43) Date of publication of application: **09.11.2005**
(21) Application number: 05000648.5
(22) Date of filing: 14.01.2005
(51) Int. Cl.: G03F 7/00, B29C 59/02

(54) **Method for manufacturing large area stamp for nanoimprint lithography**

(30) Priority: 16.01.2004 KR 2004003394
(71) Applicant: LG ELECTRONICS INC., Seoul (KR)
(72) Inventor: Lee, Ki Dong, 137-724 Seocho-gu, Seoul (KR)
(74) Representative: Kruspig, Volkmar

(57) **Abstract**

Provided is a method for manufacturing a large area stamp for nanoimprint lithography using a fabricated small area stamp. The method includes: fabricating a first small area stamp having a pattern less than a few hundred nanometers; and fabricating a second large area stamp having a pattern less than a few hundred nanometers by a step-and-repeat method using the fabricated first small area stamp.

## Description

### BACKGROUND OF THE INVENTION

### Field of the Invention

The present invention relates to a method for manufacturing a large area stamp for nanoimprint lithography.

### Description of the Related Art

Nanoimprint lithography technique is a nano device fabrication method, which was proposed by Professor Stephen Y. Chou, University of Princeton in the mid 1990's, and is in the limelight as a technique capable of taking the place of high price optical lithography.

It is the core of the nanoimprint to overcome the low productivity of the electron beam lithography by fabricating a nano-scaled stamp using an electron beam lithography or other method, printing the fabricated stamp on a thin polymer film, and repeatedly transferring the nano-scaled structure.

The nanoimprint process can be classified into a thermal curing method and an ultra violet curing method according to the curing method of thin organic film.

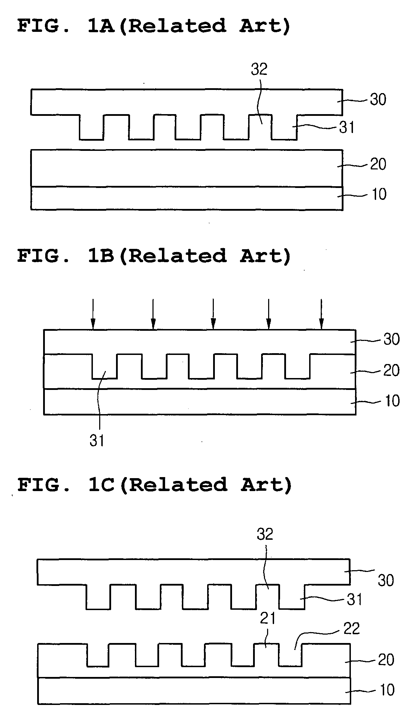

Figs. 1A through 1D show a thermal curing type nanoimprint process.

First, a thin polymer film 20 is spin-coated on a substrate 10, such as a silicon wafer, as shown in Fig. 1A. Then, a stamp 30 fabricated in advance is placed in parallel with the substrate 10 and the thin polymer film 20 is heated up to a glass transition temperature. At this time, the stamp 30 has an embossing 31 and an intaglio 32.

When the thin polymer film 20 is heated up to the glass transition temperature, the pattern of the stamp 30 is physically contacted with the thin polymer film 20 under a predetermined pressure as shown in Fig. 1B, so that the pattern of the stamp 30 is imprinted onto the thin polymer film 20. Afterwards, the thin polymer film 20 is cooled.

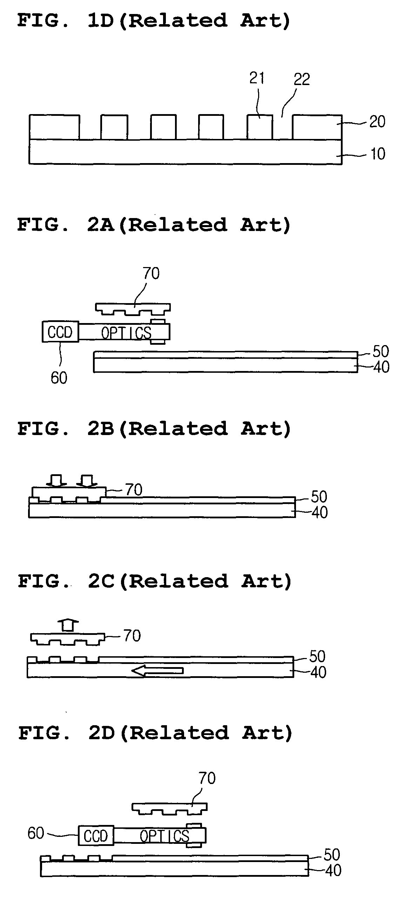

When the temperature of the thin polymer film 20 becomes below the glass transition temperature, the stamp 30 is separated from the thin polymer film 20. By performing the above steps, an intaglio 22 and an embossing corresponding to the embossing 31 and the intaglio 32 of the stamp 30 are imprinted on the thin polymer film 20. Thereafter, the imprinted thin polymer film 20 is etched such that the thin polymer patterns 21 and 22 are formed on the substrate 10 as shown in Fig. 1D. Resultantly, the nano pattern of the stamp 30 is transferred onto the thin polymer film 20 by the nanoimprint process.

Meanwhile, the ultra-violet curing method is similar to the thermal curing method, but has a difference in that the ultra-violet curing method uses a stamp made of a transparent material and a polymer cured by ultra-violet. In recent years, the ultra-violet curing method is being widely researched since it does not need a high temperature and a high pressure.

Recently, thanks to the development of related equipment technologies, a small area stamp is fabricated as shown in Figs. 2A through 2D.

Figs. 2A through 2D illustrate a step-and-repeat imprint process according to the related art.

Referring to Fig. 2A, a stamp 70 having a nano pattern is fabricated, and a polymer film 50 is formed on a substrate 40. At this time, the stamp 70 is aligned above the polymer film 50 using an alignment unit 60 provided with optics and a charge-coupled device (CCD). Specifically, the polymer film 50 is aligned with the stamp 70 using the optics, and the CCD detects whether or not the polymer film 50 is aligned with the stamp 70 to control position of the stamp 70.

When the alignment between the polymer film 50 and the stamp 70 is completed, a pattern of the stamp 70 is imprinted onto a predetermined portion of the polymer film 50 formed on the substrate 40, as shown in Fig. 2B. Thereafter, the polymer film 50 is cooled as shown in Fig. 2C, and the stamp 70 is separated form the substrate 40. After that, the pattern of the stamp 70 is transferred onto the remaining surface of the polymer film by repeating operations including moving the stamp by a predetermined step, again aligning the stamp 70 with the polymer film 50, and then imprinting the pattern of the stamp 70 onto the polymer film 50. The above method is called ' step-and-repeat' method.

Meanwhile, a step and flash imprint lithography method, which combines the ultra-violet curing method with the step-and-repeat method, is evaluated to be the most leading technology.

Thus, according to the related art, the stamp size determines a printable area at one time and it serves as an important factor to determine the productivity of the nanoimprint.

In recent researches, printing of 50 nm pattern having an interval of a few hundred nanometers on 6-inch wafer has been reported.

However, it is problematic that fabricating a large area stamp having a high-density nano pattern using the electron beam lithography results in a high cost.

Also, the step-and-repeat method has a drawback in that it is lower in the productivity per hour than a method printing an overall area at one time using a stamp having a size corresponding to the size of a substrate.

### SUMMARY OF THE INVENTION

Accordingly, the present invention is directed to a method for manufacturing a large area stamp for nanoimprint lithography that substantially obviate one or more problems due to limitations and disadvantages of the related art.

An object of the present invention is to provide a method for manufacturing a large area stamp for nanoimprint lithography, enabling it to fabricate the large area stamp by a step-and-repeat method using a small area stamp having a few hundred nanometers of fine line

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, there is provided a method for manufacturing a large area stamp for nanoimprint lithography. The method includes: depositing a thin polymer film on a substrate; coating a resist material on the thin polymer film; performing a local imprint process on the resist material using a first small area stamp; repeatedly performing the local imprint process while moving the first small area stamp, to form a resist pattern on an entire surface of the substrate; when the resist pattern is formed on the entire surface of the substrate, removing a residual layer through an etch and patterning the thin polymer film; and removing the resist material coated on the thin polymer film to complete a second large area stamp.

In another aspect of the present invention, there is provided a method for manufacturing a large area stamp for nanoimprint lithography. The method includes: fabricating a first small area stamp having a pattern less than a few hundred nanometers; and fabricating a second large area stamp having a pattern less than a few hundred nanometers by a step-and-repeat method using the fabricated first small area stamp.

According to the present invention, the small area stamp having a few hundred nanometers of pattern is fabricated and then the large area stamp is fabricated by a step-and-repeat method using the fabricated small area stamp, thereby performing an imprint for an entire area of the substrate at one time.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

Figs. 1A through 1D show a thermal curing type nanoimprint process;

Figs. 2A through 2D illustrate a step-and-repeat imprint process according to the related art;

Fig. 3 is a schematic flow chart illustrating a method for manufacturing a large area stamp for nanoimprint lithography according to an embodiment of the present invention;

Fig. 4 is a detailed flow chart illustrating a method for manufacturing a large area stamp for nanoimprint lithography according to an embodiment of the present invention;

Figs. 5A through 5H are process flow diagrams illustrating a method for manufacturing a large area stamp for nanoimprint lithography according to an embodiment of the present invention; and

Figs. 6A through 6C are perspective views showing a conversion between an intaglio and an embossing in a small area stamp, a large area stamp, and a final device.

### DETAILED DESCRIPTION OF THE INVENTION

Reference will now be made in detail to the preferred embodiments of the present invention, examples of which are illustrated in the accompanying drawings.

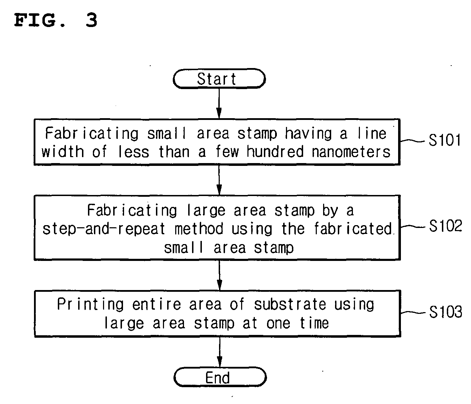

Fig. 3 is a schematic flow chart illustrating a method for manufacturing a large area stamp for nanoimprint lithography according to an embodiment of the present invention.

Referring to Fig. 3, a small area stamp having a line width of less than a few hundred nanometers is first fabricated (S101), and a large area stamp having a size corresponding to an area of a substrate is then fabricated by a step-and-repeat method (S102). At this time, since the large area stamp having the size corresponding to the size of the substrate is formed having high-density patterns of a few hundred nanometers, the entire area of the substrate is printed using the large area stamp at one time (S103).

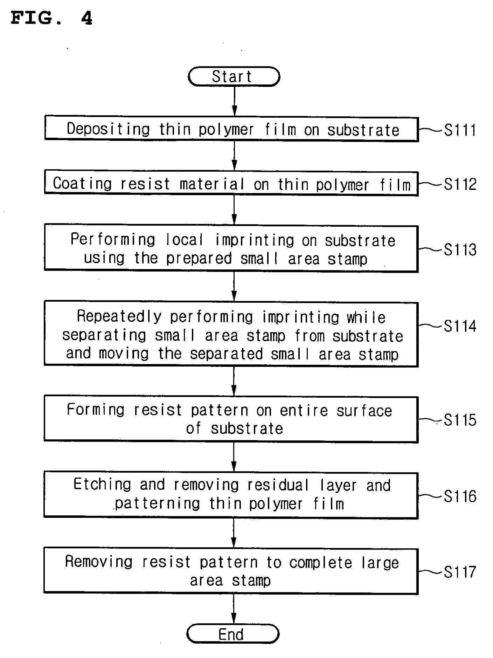

In the step S101, the small area stamp is fabricated through a semiconductor process including a deposition, exposure to light and development, and etch such that it has a fine line width of less than a few hundred nanometers (ex. 200 nm). The small area stamp is made of at least one selected from the group consisting of a semiconductor material such as silicon (Si) or silicon oxide, a metal such as nickel (Ni), a transparent material such as quartz, and a polymer.
Also, the imprint process is performed by a thermal curing method that polymer is formed by applying heat or a ultra-violet curing method that ultra-violet ray is irradiated onto polymer to cure and form the polymer while pressing the polymer.
The semiconductor material, the transparent material, the polymer and the like may be used in the thermal curing method, and among the above materials, the quartz and transparent polymer material can be also used in the ultra-violet curing method. In addition, when the small area stamp is made of nickel, it may be fabricated by a nickel plating.
Also, to form a pattern having the line width of less than a few hundred nanometers on the small area stamp, an electron beam lithography, a laser interference lithography, an optical lithography and the like can be used. In other words, the small area stamp may be fabricated by any lithography method other than the imprint method.
Meanwhile, the large area stamp is fabricated by a step-and-repeat imprint method using the small area stamp fabricated above. In the step-and-repeat imprint method, aligning, imprinting, and separating and displacing are repeated in the named order. The aligning is performed using an optical device, and the displacing may be performed with respect to the substrate or the stamp.
The method for fabricating a large area stamp using a nanoimprint lithography according to an embodiment of the present invention will now be described with reference to Fig. 4.
Referring to Fig. 4, when the small area stamp having the pattern of less than a few hundred nanometers is prepared, a thin silicon film is deposited on a substrate (S111) and a resist material is then coated on the thin silicon film (S112).
A local imprinting is performed on the substrate using the prepared small area stamp (S113), and then the small area stamp is separated from the substrate, is moved to another portion of the substrate, and the imprinting is repeated with respect to the entire surface of the substrate.
Thereafter, when a resist pattern is formed on the entire surface of the substrate by the small area stamp (S115), a residual layer of the resist material is removed by an etch and a thin polymer film is then patterned (S116). Thereafter, the resist material coated on the thin polymer film is removed, so that a large area stamp having the small area patterns of less than a few hundred nanometers is completed (S117).

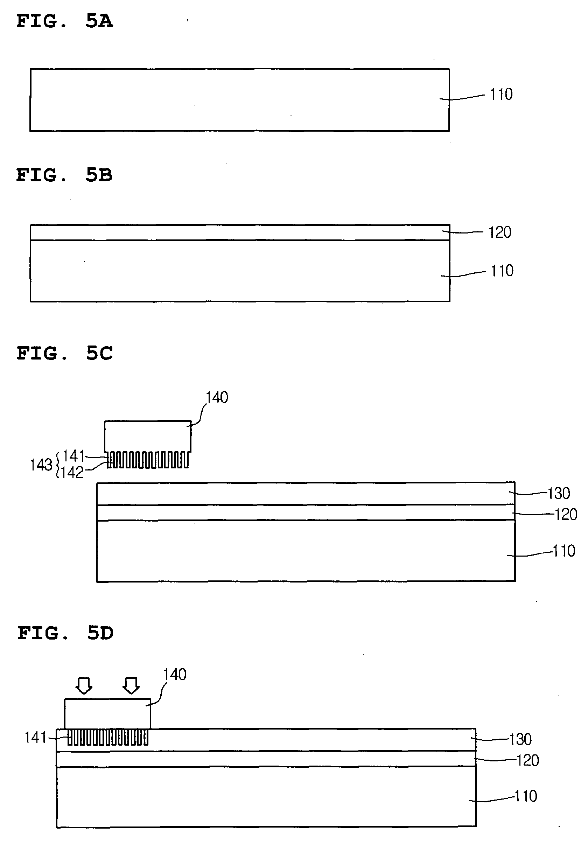

Figs. 5A through 5H are process flow diagrams illustrating a method for manufacturing a large area stamp for nanoimprint lithography according to an embodiment of the present invention.

As shown in Figs. 5A and 5B, a thin polymer film 120 is deposited on a substrate 110. The substrate may be made of silicon, glass, quartz, sapphire, alumina or the like, and the thin polymer film 120 may be made of a thin diamond film, an III-V compound thin film or the like.

Next, as shown in Fig. 5C, a resist material 130 is coated on the thin polymer film 120 and a small area stamp 140 fabricated in advance is aligned. The coating the resist material 130 is performed by a spin coating.

The small area stamp 140 is configured to have a pattern 143 including an embossing 141 and an intaglio 142 having a line width of less than a few hundred nanometers (ex. 200 nm).

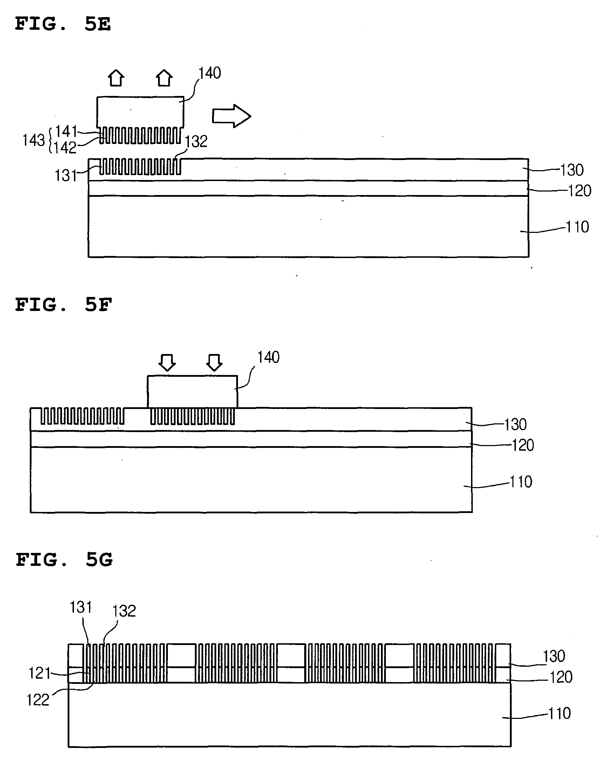

Next, as shown in Figs. 5D and 5E, a local imprinting is performed on the coated resist material 130 using the fabricated small area stamp 140. At this time, when the local imprinting is performed by a thermal curing method, it is required to heat only the local imprinting area, whereas when the local imprinting is performed by a ultra-violet method, it is required to irradiate ultra-violet onto the local imprinting area.

Also, the imprinting is performed by a thermal curing method that polymer is formed by applying heat or a ultra-violet curing method that ultra-violet ray is irradiated onto polymer to cure and form the polymer while pressing the polymer.

In addition, when the imprinting is performed by the thermal curing method, liquid resist material having a low viscosity locally drops on the substrate. Alternatively, a hard mask for an etch may be used in the mid of the imprinting depending on kinds of thin films or structures of patterns for the etch.

Next, as shown in Fig. 5F, the imprinting is repeatedly performed while moving the small area stamp 140, so that an embossing 131 and an intaglio 132 are formed in the resist material throughout the entire surface of the substrate 110. At this time, the resist material is patterned having the corresponding pattern to that of the small area stamp 140.

Next, as shown in Fig. 5G, when the forming the resist pattern 130 throughout the entire surface of the substrate 110 is completed, a residual layer, which is left without being etched during the imprinting, is removed by an oxygen plasma etch, and the underlying thin polymer film 120 is patterned by a dry etch or a wet etch.

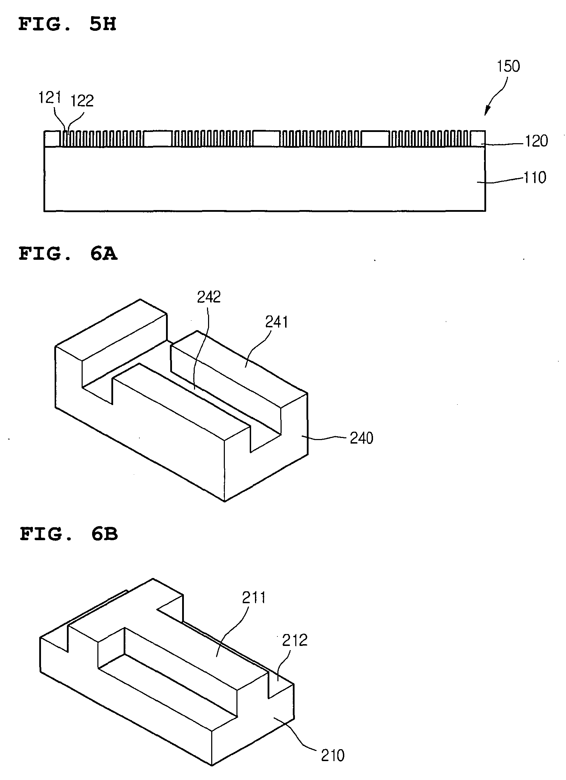

Finally, as shown in Fig. 5h, the resist pattern 130 is removed, thereby completing a large area stamp 150 having only the patterned thin polymer film 120. In other words, an intaglio 122 of the pattern of the large area stamp 150 is formed corresponding to the embossing of the pattern of the small area stamp 140 and an embossing 121 of the pattern of the large area stamp 150 is formed corresponding to the intaglio of the pattern of the small area stamp 140, so that the embossing 121 and the intaglio 122 of the pattern of the large area stamp 150 have a fine line width of less than a few hundred nanometers (about 200 nm).

Also, since the method of the present invention uses semiconductor material, metal material, transparent material, polymer and the like, many semiconductor-processing techniques can be used for the method.

Figs. 6A through 6C are perspective views showing a conversion between an intaglio and an embossing in a small area stamp, a large area stamp, and a final device.

Specifically, Fig. 6A shows a pattern of a small area stamp 240. An intaglio 242 of the pattern of the small area stamp 240 is shaped in a letter ' T' , and an embossing 241 is formed adjacent to the intaglio 242. When a large area stamp is fabricated using the small area stamp 240 at one time, the large area stamp has a shape shown in Fig. 6B.

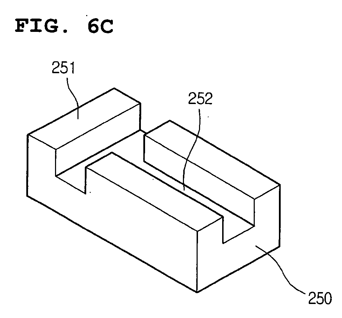

Fig. 6B shows the large area stamp 210 according to the present invention. In the large area stamp 210, a T-shaped embossing 211 is formed and an intaglio 212 is formed adjacent to the embossing 211. When the large area stamp 210 is used to form a subject device, i.e., a final device 250, on which a final pattern is being printed, the final device 250 is printed as shown in Fig. 6C.

Fig. 6C shows a pattern of the final device according to the present invention. The pattern of the final device 250 is formed in an opposite shape to the pattern of the large area stamp 210. In other words, an intaglio 252 of the pattern of the final device 20 is formed in a letter ' T' , and an embossing 251is formed adjacent to the intaglio 252.

As shown in Figs. 6A through 6C, whenever one imprinting is performed, the small area stamp 240 is converted into the large area stamp 210 and the large area stamp 210 is converted into the final device 250, i.e., whenever one imprinting is performed, embossing is converted into intaglio and intaglio is converted into embossing.

Since the large area stamp 210 is used in the imprinting for fabricating a real device, the large area stamp 210 has to have an opposite embossing and intaglio pattern to that of the real device. Also, since the large area stamp 210 is fabricated by the imprinting process using the small area stamp, the embossing and intaglio of the pattern of the small area stamp should be opposite to those of the pattern of the large area stamp.

Accordingly, the intaglio and embossing of the pattern of the real device are the same as those of the pattern of the small area stamp. Owing to the above reason, the real small area stamp is finely fabricated considering the imprint resist pattern depending on the pattern size and a variation in the size of the etched pattern.

As described above, according to the present invention, since a large area imprinting is possible by only fabricating a small area stamp having a fine pattern, the method of the present invention can be widely applied to all technical fields requiring a patterning of less than a few hundred nanometers. Also, the large area stamp is advantageous for mass production of devices.

It will be apparent to those skilled in the art that various modifications and variations can be made in the present invention. Thus, it is intended that the present invention covers the modifications and variations of this invention provided they come within the scope of the appended claims and their equivalents.

The claims refer to examples of preferred embodiments of the invention. However, the invention also refers to the use of any single feature and subcombination of features which are disclosed in the claims, the description and / or the drawings.

## Claims

1. A method for manufacturing a large area stamp for nanoimprint lithography, the method comprising:
depositing a thin polymer film on a substrate;
coating a resist material on the thin polymer film;
performing a local imprint process on the resist material using a first small area stamp;
repeatedly performing the local imprint process while moving the first small area stamp, to form a resist pattern on an entire surface of the substrate;
when the resist pattern is formed on the entire surface of the substrate, removing a residual layer through an etch and patterning the thin polymer film; and
removing the resist material coated on the thin polymer film to complete a second large area stamp.

2. The method according to claim 1, wherein the first stamp is made of at least one selected from the group consisting of a semiconductor material including silicon (Si) and silicon dioxide (SiO₂), a metal including nickel (Ni), a transparent material including quartz, and a polymer.

3. The method according to claim 1, wherein the removing the residual layer is performed by an oxygen plasma etch.

4. The method according to claim 1, wherein the patterning the thin polymer film is performed by a dry etch.

5. The method according to claim 1, wherein the patterning the thin polymer film is performed by a wet etch.

6. The method according to claim 1, wherein the imprint process is performed by a step-and-repeat imprint method.

7. The method according to claim 1, wherein the imprint process is performed by a thermal curing method.

8. The method according to claim 1, wherein the imprint process is performed by a ultra-violet curing method.

9. The method according to claim 1, wherein the first stamp and the second stamp have patterns corresponding to each other, each of the corresponding patterns having a few hundred nanometer of line width.

10. A method for manufacturing a large area stamp for nanoimprint lithography, the method comprising:
fabricating a first small area stamp having a pattern less than a few hundred nanometers; and
fabricating a second large area stamp having a pattern less than a few hundred nanometers by a step-and-repeat method using the fabricated first small area stamp.

11. The method according to claim 10, wherein the patterns of the first and second stamps have a line width of less than approximately 200 nm.

12. The method according to claim 10, wherein the first stamp is fabricated by one selected from the group consisting of an electron beam lithography, a laser interference lithography, an optical lithography.

13. The method according to claim 10, wherein the first stamp is made of a semiconductor material including silicon and silicon oxide.

14. The method according to claim 10, wherein the first stamp is made of a metal material including nickel.

15. The method according to claim 10, wherein the first stamp is made of a transparent material including quartz, or of polymer.

16. The method according to claim 10, wherein the fabricating the second stamp comprising:
depositing a thin polymer film on a substrate;
coating a resist material on the thin polymer film;
performing a local imprint process on the resist material using a first small area stamp;
repeatedly performing the local imprint process while moving the first small area stamp, to form a resist pattern on an entire surface of the substrate;
removing a residual layer of the resist material;
patterning the thin polymer film using the resist pattern as a mask; and
removing the resist material coated on the thin polymer film to complete a second large area stamp.

17. The method according to claim 16, wherein the removing the residual layer of the resist material is performed by an oxygen plasma etch.

18. The method according to claim 16, wherein the patterning the thin polymer film is performed by a dry etch or a wet etch.

19. The method according to claim 16, wherein the imprint process is performed by a thermal curing method or a ultra-violet method.
